(19) Europäisches Patentamt
European Patent Office
Office européen des brevets

(11) EP 4 577 026 A1

(12) **EUROPEAN PATENT APPLICATION**
published in accordance with Art. 153(4) EPC

(43) Date of publication:
**25.06.2025 Bulletin 2025/26**

(21) Application number: **23863118.8**

(22) Date of filing: **01.09.2023**

(51) International Patent Classification (IPC):
***H10N 10/01*** *(2023.01)* ***H10N 10/855*** *(2023.01)*
***H10N 10/856*** *(2023.01)* ***H10N 10/857*** *(2023.01)*

(52) Cooperative Patent Classification (CPC):
**H10N 10/01; H10N 10/855; H10N 10/856; H10N 10/857**

(86) International application number:
**PCT/JP2023/032091**

(87) International publication number:
**WO 2024/053580 (14.03.2024 Gazette 2024/11)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **06.09.2022 JP 2022141508**

(71) Applicant: **Denka Company Limited**
**Tokyo 103-8338 (JP)**

(72) Inventors:
- **MAEDA, Ryota**
  **Tokyo 103-8338 (JP)**
- **ASAMI, Takeshi**
  **Tokyo 103-8338 (JP)**
- **NIWA, Ryota**
  **Tokyo 103-8338 (JP)**

(74) Representative: **Gulde & Partner**
**Patent- und Rechtsanwaltskanzlei mbB**
**Berliner Freiheit 2**
**10785 Berlin (DE)**

(54) **N-TYPE MATERIAL FOR THERMOELECTRIC CONVERSION, METHOD FOR PRODUCING SAME, THERMOELECTRIC CONVERSION ELEMENT, AND DOPANT**

(57) Disclosed is a method for producing an n-type material for thermoelectric conversion, the method including a step of doping, with a dopant, a p-type material for thermoelectric conversion containing carbon nanotubes and a conductive resin, and the dopant contains at least one compound selected from the group consisting of a sulfinate salt and a dithionite salt. The step includes an impregnation step of impregnating at least a part of the p-type material for thermoelectric conversion with a dopant solution containing the dopant and a solvent, and a solvent removing step of removing the solvent. The concentration of the dopant in the dopant solution is 15 mM or more.



Processed by Luminess, 75001 PARIS (FR)

## Description

### Technical Field

The present invention relates to an n-type material for thermoelectric conversion, a method for producing the same, a thermoelectric conversion element, and a dopant.

### Background Art

Thermoelectric conversion is a technique for directly converting heat into electricity by utilizing Seebeck effect, and has attracted attention as an energy recovery technique for converting waste heat or the like generated when fossil fuel is used into electricity.

A thermoelectric conversion element used in such a field is preferably a bipolar element that includes both a material exhibiting p-type conductivity and a material exhibiting n-type conductivity, but a nanomaterial often exhibits p-type conductivity. Therefore, there is a demand for a technique for converting a nanomaterial exhibiting p-type conductivity into a nanomaterial exhibiting n-type conductivity.

For example, Patent Literature 1 discloses an n-type dopant for converting a nanomaterial exhibiting p-type conductivity into a nanomaterial exhibiting n-type conductivity.

Note that, whether a nanomaterial exhibits p-type conductivity or n-type conductivity can be determined depending on whether a Seebeck coefficient is positive or negative. When the Seebeck coefficient is positive, the nanomaterial exhibits p-type conductivity, and when the Seebeck coefficient is negative, the nanomaterial exhibits n-type conductivity.

### Citation List

### Patent Literature

Patent Literature 1: WO 2015/198980 A1

### Summary of Invention

### Technical Problem

An object of the present invention is primarily to provide a method for producing an n-type material for thermoelectric conversion capable of converting a p-type material for thermoelectric conversion into an n-type material for thermoelectric conversion.

### Solution to Problem

As a result of intensive studies to solve the above problems, the present inventors have found that a predetermined p-type material for thermoelectric conversion can be converted into n-type by doping the predetermined p-type material for thermoelectric conversion with a predetermined dopant, and have completed the present invention.

That is, the present invention provides a method for producing an n-type material for thermoelectric conversion according to [1] and [2], an n-type material for thermoelectric conversion according to [3] and [4], a thermoelectric conversion element according to [5], and a dopant according to [6] and [7].

[1] A method for producing an n-type material for thermoelectric conversion, the method including a step of doping a p-type material for thermoelectric conversion containing carbon nanotubes and a conductive resin with a dopant, the dopant containing at least one compound selected from the group consisting of a sulfinate salt and a dithionite salt, in which the step includes: an impregnation step of impregnating at least a part of the p-type material for thermoelectric conversion with a dopant solution containing the dopant and a solvent; and a solvent removing step of removing the solvent, and a concentration of the dopant in the dopant solution is 15 mM or more.

[2] The method according to [1], in which the dopant contains at least one compound selected from the group consisting of sodium methanesulfinate, sodium hydroxymethanesulfinate, and sodium dithionite.

[3] An n-type material for thermoelectric conversion obtained by doping a p-type material for thermoelectric conversion containing carbon nanotubes and a conductive resin with a dopant, in which the dopant contains at

least one compound selected from the group consisting of a sulfinate salt and a dithionite salt.

[4] The n-type material for thermoelectric conversion according to [3], in which the dopant contains at least one compound selected from the group consisting of sodium methanesulfinate, sodium hydroxymethanesulfinate, and sodium dithionite.

[5] A thermoelectric conversion element comprising the n-type material for thermoelectric conversion according to [3] or [4].

[6] A dopant which is doped into a p-type material for thermoelectric conversion containing carbon nanotubes and a conductive resin, and converts the p-type material for thermoelectric conversion into n-type, in which the dopant contains at least one compound selected from the group consisting of a sulfinate salt and a dithionite salt.

[7] The dopant according to [6], in which the dopant contains at least one compound selected from the group consisting of sodium methanesulfinate, sodium hydroxymethanesulfinate, and sodium dithionite.

## Advantageous Effects of Invention

According to the present invention, the method for producing an n-type material for thermoelectric conversion capable of converting a p-type material for thermoelectric conversion into an n-type material for thermoelectric conversion is provided. In addition, the n-type material for thermoelectric conversion obtained by such a production method is provided. Furthermore, according to the present invention, the thermoelectric conversion element with such an n-type material for thermoelectric conversion is provided. Moreover, according to the present invention, the novel dopant capable of being used for forming such an n-type material for thermoelectric conversion is provided.

## Description of Embodiments

Hereinbelow, embodiments of the present invention will be described. Note that the present invention is not limited to the following embodiments.

In the present specification, a numerical range indicated using "to" indicates a range including numerical values described before and after "to" as a minimum value and a maximum value, respectively. In the numerical ranges described in stages in the present specification, the upper limit value or the lower limit value described in one numerical range may be replaced with the upper limit value or the lower limit value of the numerical range described in other stages. In the numerical range described in the present specification, the upper limit value or the lower limit value of the numerical range may be replaced with a value described in Examples.

In the present specification, materials exemplified below may be used alone, or may be used in combination of two or more thereof within the range that satisfies conditions, unless otherwise specified. The content of each component means a total amount of a plurality of substances, unless otherwise specified, in a case where there is a plurality of substances corresponding to each component.

In the present specification, whether a material for thermoelectric conversion exhibits p-type conductivity or n-type conductivity can be determined depending on whether a Seebeck coefficient is positive or negative. When the Seebeck coefficient is positive, the material for thermoelectric conversion exhibits p-type conductivity, and a material having such properties is referred to as a p-type material for thermoelectric conversion. When the Seebeck coefficient is negative, the material for thermoelectric conversion exhibits n-type conductivity, and a material having such properties is referred to as an n-type material for thermoelectric conversion. The Seebeck coefficient can be measured by, for example, a measurement method in Examples described later, and the polarity of the material for thermoelectric conversion can be determined based on whether the measured value is positive or negative.

<N-Type Material for Thermoelectric Conversion>

An n-type material for thermoelectric conversion according to one embodiment is obtained by doping a p-type material for thermoelectric conversion with a dopant. A part of the p-type material for thermoelectric conversion doped with the dopant becomes an n-type material for thermoelectric conversion.

(P-Type Material for Thermoelectric Conversion)

The p-type material for thermoelectric conversion contains carbon nanotubes and a conductive resin.

The carbon nanotubes may include any of single-walled carbon nanotubes, double-walled carbon nanotubes,

and multi-walled carbon nanotubes (three-walled or more), and preferably includes single-walled carbon nanotubes from the viewpoint of further improving a Seebeck coefficient and electric conductivity of a material for thermoelectric conversion (the p-type material for thermoelectric conversion and a n-type material for thermoelectric conversion described later).

The carbon nanotubes preferably include single-walled carbon nanotubes. The content proportion of the single-walled carbon nanotubes to the total amount of the carbon nanotubes is preferably 25% by mass or more and more preferably 50% by mass or more, and may be, for example, 100% by mass.

The diameter of the single-walled carbon nanotube is not particularly limited, and may be, for example, 20 nm or less, preferably 10 nm or less, and more preferably 3 nm or less. Note that the lower limit of the diameter of the single-walled carbon nanotube may be, for example, 0.4 nm or more, or 0.5 nm or more.

In the present specification, the diameter of the single-walled carbon nanotube can be determined by Raman spectroscopy using the wavenumber ($\omega(cm^{-1})$) of peaks appearing at 100 to 300 $cm^{-1}$ according to the formula: Diameter (nm) = $248/\omega$.

As a method for evaluating single-walled carbon nanotubes, a G/D ratio in Laser Raman spectroscopy is known. In the present embodiment, the G/D ratio of the single-walled carbon nanotubes in laser Raman spectroscopy at a wavelength of 532 nm is preferably 10 or more, and more preferably 20 or more. When such single-walled carbon nanotubes are used, a p-type material for thermoelectric conversion that is further excellent in electric conductivity is likely to be obtained. Note that the upper limit of the G/D ratio is not particularly limited, and may be, for example, 500 or less or 300 or less.

The content of the carbon nanotubes may be, for example, 20% by mass or more, and is preferably 30% by mass or more and more preferably 40% by mass or more, with respect to the total amount of solid content of the p-type material for thermoelectric conversion. The content of the carbon nanotubes may be, for example, 99% by mass or less, and is preferably 95% by mass or less and more preferably 90% by mass or less, with respect to the total amount of solid content of the p-type material for thermoelectric conversion.

The conductive resin is not particularly limited, and a known conductive resin used for the p-type material for thermoelectric conversion can be used. Examples of the conductive resin include those including a polyaniline-based conductive polymer, a polythiophene-based conductive polymer, a polypyrrole-based conductive polymer, a polyacetylene-based conductive polymer, a polyphenylene-based conductive polymer, and a polyphenylenevinylene-based conductive polymer. As the polythiophene-based conductive polymer, poly(3,4-ethylenedioxythiophene) can be exemplified.

The conductive resin may be a conductive resin containing poly(3,4-ethylenedioxythiophene) (hereinafter, may be referred to as "PEDOT") and an electron acceptor. When such a conductive resin is used, the electric conductivity of the p-type material for thermoelectric conversion is likely to be further increased.

Examples of the electron acceptor include polystyrene sulfonic acid, polyvinyl sulfonic acid, poly(meth)acrylic acid, polyvinyl sulfonic acid, toluenesulfonic acid, dodecylbenzenesulfonic acid, camphorsulfonic acid, bis(2-ethylhexyl) sulfosuccinate, chlorine, bromine, iodine, phosphorus pentafluoride, arsenic pentafluoride, boron trifluoride, hydrogen chloride, sulfuric acid, nitric acid, tetrafluoroboric acid, perchloric acid, iron(III) chloride, and tetracyanoquinodimethane. From the viewpoint of further improving the electric conductivity of the p-type material for thermoelectric conversion, the electron acceptor may be polystyrene sulfonic acid (hereinafter, may be referred to as "PSS").

The content of the conductive resin may be, for example, 1% by mass or more, and is preferably 5% by mass or more and more preferably 10% by mass or more, with respect to the total amount of solid content of the p-type material for thermoelectric conversion. The content of the conductive resin may be, for example, 80% by mass or less, and is preferably 70% by mass or less and more preferably 60% by mass or less, with respect to the total amount of solid content of the p-type material for thermoelectric conversion.

(Dopant)

In the present specification, the dopant means a substance that modifies a Seebeck coefficient of a material to be doped with the dopant.

In the present specification, the phrase "changing a Seebeck coefficient" means decreasing a Seebeck coefficient value or changing a Seebeck coefficient value from a positive value to a negative value.

The dopant contains at least one compound selected from the group consisting of a sulfinate salt and a dithionite salt. By doping the p-type material for thermoelectric conversion with such a dopant, the Seebeck coefficient can be modified, resulting in an n-type material for thermoelectric conversion exhibiting n-type conductivity.

The reason why such an effect is exhibited is not necessarily clear, but it is considered that this is because the Fermi level of the p-type material for thermoelectric conversion is modified due to either a decrease in the carrier concentration of holes or an increase in the carrier concentration of electrons in the p-type material for thermoelectric conversion, or both of them.

The sulfinate salt is a salt composed of a monovalent or divalent cation and a sulfinate anion. Examples of the sulfinate salt include a compound represented by the following Formula (1) and a compound represented by the following Formula (2).

[Chem. 1]

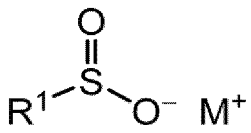

(1)

In Formula (1), $R^1$ represents a monovalent organic group, and $M^+$ represents a monovalent cation.

The monovalent organic group represented by $R^1$ may be, for example, an alkyl group, a fluoroalkyl group, a hydroxyalkyl group, an aryl group, a monovalent heterocyclic group, or an aralkyl group.

The alkyl group may have, for example, 1 to 20, 1 to 10, 1 to 6, or 1 to 3 carbon atoms. The alkyl group may be any one of a linear alkyl group, a branched alkyl group, or a cyclic alkyl group. Examples of the linear alkyl group include a methyl group, an ethyl group, an n-propyl group, an n-butyl group, and an n-hexyl group. Examples of the branched alkyl group include an isopropyl group, an isobutyl group, a sec-butyl group, and a tert-butyl group. Examples of the cyclic alkyl group include a cyclopentyl group and a cyclohexyl group. The alkyl group may be, for example, a methyl group.

The fluoroalkyl group means an alkyl group with at least some of hydrogen atoms of the alkyl group exemplified above substituted with a fluorine atom. Specific examples of the fluoroalkyl group include a fluoromethyl group, a difluoromethyl group, a trifluoromethyl group, a 2-fluoroethyl group, a 1,2-difluoroethyl group, a 2,2-difluoroethyl group, and a perfluoroethyl group. The fluoroalkyl group may be, for example, a trifluoromethyl group.

The hydroxyalkyl group means an alkyl group with at least some of hydrogen atoms of the alkyl group exemplified above substituted with a hydroxy group. Specific examples of the hydroxyalkyl group include a hydroxymethyl group and a hydroxyethyl group. The hydroxyalkyl group may be, for example, a hydroxymethyl group.

The aryl group means a group obtained by removing one hydrogen atom directly bonded to a carbon atom constituting a ring from an aromatic hydrocarbon. The aromatic hydrocarbon includes benzene, a fused cyclic hydrocarbon compound containing benzene, and a compound in which two or more selected from the group consisting of benzene and a fused cyclic hydrocarbon compound containing benzene are directly bonded. Specific examples of the aryl group include a phenyl group, a 1-naphthyl group, a 2-naphthyl group, a 1-anthracenyl group, a 2-anthracenyl group, and a 9-anthracenyl group. Some of hydrogen atoms of the aryl group may be substituted with an alkyl group, a fluorine atom, or the like.

The monovalent heterocyclic group means a group obtained by removing one hydrogen atom directly bonded to a carbon atom constituting a ring from a heterocyclic compound such as furan, thiophene, pyrrole, tetrahydrofuran, tetrahydrothiophene, or pyrrolidine. Specific examples of the monovalent heterocyclic group include a furyl group, a thienyl group, a pyrrolyl group, a tetrahydrofuryl group, a tetrahydrothienyl group, and a pyrrolidinyl group. Some of hydrogen atoms of the monovalent heterocyclic group may be substituted with an alkyl group, a fluorine atom, or the like.

The aralkyl group means an alkyl group with at least some of hydrogen atoms of the alkyl group exemplified above substituted with the aryl group exemplified above. Examples of the aralkyl group include a benzyl group, a (2-methylphenyl)methyl group, a (3-methylphenyl)methyl group, a (4-methylphenyl)methyl group, a (2,4-dimethylphenyl)methyl group, a (ethylphenyl)methyl group, and a naphthylmethyl group.

Examples of the monovalent cation include alkali metal ions such as a lithium ion, a sodium ion, and a potassium ion. The monovalent cation may be, for example, a sodium ion.

Specific examples of the compound represented by Formula (1) include sodium methanesulfinate, sodium hydroxymethanesulfinate (Rongalite), sodium triflate, sodium 1,1-difluoroethanesulfinate, sodium cyclohexanesulfinate, and sodium tetrahydrofuran sulfinate.

[Chem. 2]

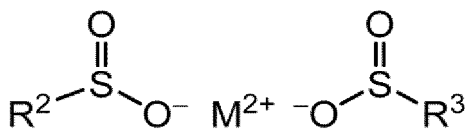

(2)

In Formula (2), $R^2$ and $R^3$ each independently represent a monovalent organic group, and $M^{2+}$ represents a divalent cation.

The monovalent organic group represented by each of $R^2$ and $R^3$ may be, for example, an alkyl group, a

fluoroalkyl group, a hydroxyalkyl group, an aryl group, a monovalent heterocyclic group, or an aralkyl group.

Examples of the alkyl group, fluoroalkyl group, hydroxyalkyl group, aryl group, monovalent heterocyclic group, or aralkyl group represented by each of $R^2$ and $R^3$ include the same groups as the alkyl group, fluoroalkyl group, hydroxyalkyl group, aryl group, monovalent heterocyclic group, or aralkyl group represented by $R^1$. The alkyl group may be, for example, a methyl group. The hydroxyalkyl group may be, for example, a hydroxymethyl group. The fluoroalkyl group may be, for example, a trifluoromethyl group. $R^2$ and $R^3$ may be the same as or different from each other, but are preferably the same as each other.

Examples of the divalent cation include alkaline earth metal ions such as calcium ions and magnesium ions; and Group 12 element ions such as zinc ions.

Specific examples of the compound represented by Formula (2) include bis(hydroxymethanesulfinic acid) calcium, bis(hydroxymethanesulfinic acid)zinc (safoline), bis(trifluoromethanesulfinic acid)zinc, bis(difluoromethanesulfinic acid)zinc, and bis(benzenesulfinic acid)zinc.

The dithionite salt is a salt composed of a monovalent or divalent cation and a dithionite anion. Examples of the monovalent cation include alkali metal ions. Examples of the divalent cation include alkaline earth metal ions and Group 12 element ions.

Specific examples of the dithionite salt include sodium dithionite and zinc dithionite.

The dopant may contain at least one compound selected from the group consisting of sodium methanesulfinate, sodium hydroxymethanesulfinate, and sodium dithionite, or may contain sodium hydroxymethanesulfinate, from the viewpoint of easily obtaining the n-type material for thermoelectric conversion.

The dopant may contain, as necessary, a component in addition to the at least one compound selected from the group consisting of a sulfinate salt and a dithionite salt. Such a component is not particularly limited as long as it does not inhibit the function of the dopant, and examples thereof include water and a solvent such as an organic solvent.

A method for producing the n-type material for thermoelectric conversion obtained by doping the p-type material for thermoelectric conversion with a predetermined dopant is not particularly limited, but for example, the production can be carried out by the following method.

<Method for Producing N-Type Material for Thermoelectric Conversion>

A producing method according to one embodiment includes a step of doping a p-type material for thermoelectric conversion containing carbon nanotubes and a conductive resin with a dopant (hereinafter, may be referred to as a "doping step"). The doping step includes an impregnation step and a solvent removing step.

(Impregnation Step)

The present step is impregnating at least a part of the p-type material for thermoelectric conversion with a dopant solution containing the dopant and a solvent (first solvent).

The dopant solution can be obtained by mixing the dopant and the first solvent. Examples of the first solvent include water, acetonitrile, acetone, methanol, ethanol, 1-propanol, 2-propanol, ethylene glycol, dimethyl sulfoxide (DMSO), N-methylpyrrolidone, N,N-dimethylformamide, and N,N-dimethylacetamide. The first solvent may contain, for example, water.

The concentration of the dopant in the dopant solution is 15 mM or more. In a case where the concentration of the dopant in the dopant solution is 15 mM or more, the p-type material for thermoelectric conversion is readily converted into n-type. The concentration of the dopant in the dopant solution may be 18 mM or more, 20 mM or more, 25 mM or more, 30 mM or more, 35 mM or more, 40 mM or more, 45 mM or more, or 50 mM or more from the viewpoint of improving the electric conductivity. The upper limit of the concentration of the dopant in the dopant solution is not particularly limited, and may be, for example, 1,000 mM or less, 500 mM or less, 200 mM or less, 150 mM or less, or 100 mM or less.

The dopant solution may contain other components in addition to the dopant and the first solvent as long as the effects of the present invention are not impaired. Examples of the other components include a binder resin, an antioxidant, a thickener, and a surfactant.

The method for impregnating a material for thermoelectric conversion with the dopant solution is not particularly limited, and examples thereof include a method for adding the dopant solution to a material for thermoelectric conversion and a method for immersing a material for thermoelectric conversion in the dopant solution. In a case where a part of the p-type material for thermoelectric conversion is impregnated with the dopant solution containing the dopant and the first solvent, it is preferable to use the method for adding the dopant solution to the material for thermoelectric conversion. On the other hand, in a case where the entire p-type material for thermoelectric conversion is impregnated with the dopant solution containing the dopant and the first solvent, it is preferable to use the method for immersing the material for thermoelectric conversion in the dopant solution.

The method for impregnating the material for thermoelectric conversion with the dopant solution may be, in one

embodiment, a method including: applying a mixed solution containing carbon nanotubes, a conductive resin, and a solvent (second solvent) onto a support and removing the second solvent from the applied mixed solution to form a coating film containing a p-type material for thermoelectric conversion; and impregnating the obtained coating film with the dopant solution. The method may further include, after forming the coating film, exposing the obtained coating film to a solvent (third solvent) and impregnating the coating film with at least a partial amount of the third solvent.

The mixed solution can be obtained by mixing the carbon nanotubes, the conductive resin, a dispersant, and the second solvent. Examples of the dispersant include a resin and a surfactant. The second solvent can be exemplified by the same solvent as the first solvent of the dopant solution. The second solvent may contain, for example, water. The mixed solution can contain other components in addition to the carbon nanotubes, the conductive resin, the dispersant, and the second solvent.

Examples of the support include resin substrates such as polyimide, polyethylene terephthalate, polyethylene naphthalate, polyethylene isophthalate, polybutylene terephthalate, polycarbonate, polyether ether ketone, polyphenyl sulfide, and polysulfone; and inorganic substrates such as glass, copper, silver, gold, and aluminum. Among these, since the obtained material for thermoelectric conversion exhibits favorable flexibility, the support may be a resin substrate selected from the group consisting of polyimide, polyethylene terephthalate, and polyethylene naphthalate.

The method for applying the mixed solution is not particularly limited, and for example, a doctor blade method, a casting method, a dip coating method, a spray coating method, a spin coating method, or the like can be appropriately selected.

The method for removing the second solvent from the applied mixed solution is not particularly limited, and can be appropriately selected from known methods such as heating and decompression depending on the type of the second solvent, and two or more methods may be combined.

In this way, the coating film containing a p-type material for thermoelectric conversion can be obtained. A partial amount of the second solvent may remain in the coating film.

In the case where the coating film is exposed to the third solvent, the third solvent can be exemplified by the same solvent as the first solvent of the dopant solution. The third solvent may contain dimethyl sulfoxide (DMSO). When the third solvent contains dimethyl sulfoxide (DMSO), an insulating component slightly mixed in the material for thermoelectric conversion is easily removed, and the mobility of the material for thermoelectric conversion is likely to be further improved.

The method for exposing the coating film to the third solvent is not particularly limited, and examples thereof include a method for immersing the coating film in the third solvent, and a method for applying the third solvent onto the coating film. Among these, since the coating film can be easily exposed to the third solvent while the shape of the coating film is maintained, as the method for exposing the obtained coating film to the third solvent, the method for immersing the coating film in the third solvent may be employed.

In exposing the coating film to the third solvent, a coating film impregnated with the third solvent is obtained, and the coating film is subjected to the next step. Note that, the residual amount of the third solvent used in exposing the coating film to the third solvent, excluding the amount of the third solvent impregnated or adhered to the coating film, may be removed at the end of the present step. For example, in a case where the coating film is immersed in the third solvent in the present step, the coating film may be taken out from the third solvent and subjected to the next step.

Subsequently, the obtained coating film is impregnated with the dopant solution. Examples of the method for impregnating the obtained coating film with the dopant solution include a method for adding the dopant solution to the obtained coating film and a method for immersing the obtained coating film in the dopant solution.

Examples of the method for adding the dopant solution to the obtained coating film include a method for dropwise adding the dopant solution with a pipettor. The amount of dropwise addition of the dopant solution is not particularly limited, and may be, for example, 0.01 to 0.5 $mL/cm^2$. The dopant solution may be added dropwise at room temperature or may be added dropwise while being heated. The heating temperature is not particularly limited, and may be, for example, 40°C or higher, 50°C or higher, or 60°C or higher, and may be 250°C or lower, 225°C or lower, or 200°C or lower.

In the method for immersing the obtained coating film in the dopant solution, the time for immersing the coating film in the dopant solution may be, for example, 30 seconds to 72 hours, or may be one minute to 24 hours.

In the impregnation step, a material (coating film) impregnated with the dopant solution is obtained, and the material (coating film) is subjected to the solvent removing step. Note that, the residual amount of the first solvent used in the impregnation step, excluding the amount of the first solvent impregnated or adhered to the material, may be removed at the end of the impregnation step. For example, in a case where the material is immersed in the dopant solution in the impregnation step, the material may be taken out from the dopant solution and subjected to the solvent removing step.

(Solvent Removing Step)

The present step is removing the first solvent from the p-type material for thermoelectric conversion impregnated with the dopant solution. In the present step, it is not always necessary to remove all of the first solvent, and the first solvent may remain in an amount within a range sufficient to achieve the functioning of the n-type material for thermoelectric

conversion.

The solvent removing step may be, for example, removing the first solvent by natural drying, or removing the first solvent by performing heat treatment, decompression treatment, or the like.

The solvent removing step may include a step of heat-treating the material for thermoelectric conversion impregnated with the first solvent. In heat-treating the material for thermoelectric conversion, it is conceivable that the first solvent whose compatibility with the conductive resin has been improved upon heating causes the conductive resin in the material to flow, so that voids between the carbon nanotubes are filled and a denser structure is formed. Therefore, since the solvent removing step includes such a step, more remarkable improvement in thermoelectric conversion characteristics of the n-type material for thermoelectric conversion can be expected.

The temperature during the heat treatment is not particularly limited, and may be, for example, 40°C or higher, and is preferably 50°C or higher, and more preferably 60°C or higher. As the temperature during the heat treatment is increased, the Seebeck coefficient of the material for thermoelectric conversion is likely to be improved. In addition, the temperature during the heat treatment may be, for example, 250°C or lower, and is preferably 225°C or lower, and more preferably 200°C or lower. As the temperature during the heat treatment is decreased, the electric conductivity of the material for thermoelectric conversion is likely to be improved. The Seebeck coefficient and the electric conductivity of the material for thermoelectric conversion are likely to vary depending on the temperature during the heat treatment. Therefore, the temperature during the heat treatment can be appropriately selected, for example, within the above-described range, in view of the balance between the numerical values of the Seebeck coefficient and the electric conductivity.

The time for the heat treatment is not particularly limited. The time for the heat treatment may be, for example, one minute or more and is preferably 10 minutes or more, and may be 12 hours or less and is preferably six hours or less.

The heat treatment is not necessarily intended to remove the first solvent, and the solvent removing step may be performed after the heat treatment.

In this way, a thermoelectric conversion film containing the n-type material for thermoelectric conversion can be obtained.

A part of the p-type material for thermoelectric conversion doped with the dopant becomes an n-type material for thermoelectric conversion. In a case where the p-type material for thermoelectric conversion is converted into the n-type material for thermoelectric conversion, the entire p-type material for thermoelectric conversion may be doped with the dopant to form the n-type material for thermoelectric conversion, or a part of the p-type material for thermoelectric conversion may be doped with the dopant to form a composite of the p-type material for thermoelectric conversion and the n-type material for thermoelectric conversion.

In one embodiment of the method for producing an n-type material for thermoelectric conversion, the impregnation step may be a step of impregnating a part of a resin layer containing the p-type material for thermoelectric conversion with the dopant solution containing the dopant and the first solvent, and the solvent removing step may be a step of removing the first solvent from the resin layer after impregnation with the dopant solution to obtain a thermoelectric conversion film containing the p-type material for thermoelectric conversion and the n-type material for thermoelectric conversion. According to such an embodiment, the thermoelectric conversion film containing the p-type material and the n-type material can be easily obtained. In addition, in such an embodiment, a thermoelectric conversion film having a desired p/n configuration can be easily obtained by appropriately setting an impregnation range of the dopant solution in the impregnation step.

The shape of the n-type material for thermoelectric conversion is not particularly limited. For example, as described above, the coating film containing the p-type material for thermoelectric conversion formed on the support may be doped with a predetermined dopant to obtain a thermoelectric conversion film containing the n-type material for thermoelectric conversion as a film supported by the support.

The film thicknesses of the coating film containing the p-type material for thermoelectric conversion and the thermoelectric conversion film containing the n-type material for thermoelectric conversion are preferably 100 nm to 1 mm, more preferably 200 nm to 800 μm, and still more preferably 300 nm to 600 μm from the viewpoint of obtaining appropriate electric resistance and excellent flexibility.

The n-type material for thermoelectric conversion of the present embodiment can be suitably used as an n-type material for a thermoelectric conversion element. The n-type material for thermoelectric conversion of the present embodiment can also be suitably used for applications such as a Peltier element and a temperature sensor.

<Thermoelectric Conversion Element>

A thermoelectric conversion element of one embodiment contains the n-type material for thermoelectric conversion.

The thermoelectric conversion element of the present embodiment may include, for example, two conductive substrates and a thermoelectric conversion film disposed between the conductive substrates and containing the n-type

material for thermoelectric conversion. In addition, a thermoelectric conversion layer may contain the p-type material for thermoelectric conversion.

As the conductive substrates, various known conductive substrates can be used. Due to the difficulty of corrosion and elution, the conductive substrates may contain at least one conductive material selected from the group consisting of tin-doped indium oxide (ITO), fluorine-doped tin oxide (FTO), and stainless steel.

The two conductive substrates can also be referred to as a first electrode and a second electrode, respectively.

The thermoelectric conversion element of the present embodiment can be manufactured by, for example, a method including a lamination step of disposing the thermoelectric conversion film containing the n-type material for thermoelectric conversion and the p-type material for thermoelectric conversion over the conductive substrate.

The thermoelectric conversion element of the present embodiment can be produced by, for example, a method including a first lamination step of disposing a resin layer containing a p-type material for thermoelectric conversion on one conductive substrate, an impregnation step of impregnating a part of the resin layer with a dopant solution containing a dopant and a first solvent, a solvent removing step of removing the first solvent to obtain a thermoelectric conversion film containing an n-type material for thermoelectric conversion and the p-type material for thermoelectric conversion, and a second lamination step of laminating the other conductive substrate on the thermoelectric conversion film.

The thermoelectric conversion element may further include a configuration other than the above. For example, the thermoelectric conversion element may further include: a sealing material for sealing the thermoelectric conversion film; a wiring for electrically connecting thermoelectric conversion elements to each other or for extracting electric power to an external circuit; a heat insulation material or thermal conductive material for controlling the thermal conductivity of the thermoelectric conversion element, and the like.

Although the preferred embodiments of the present invention have been described above, the present invention is not limited to the above embodiments.

## Examples

Hereinbelow, the present invention will be described in more detail with reference to examples, but the present invention is not limited to these examples. Hereinbelow, unless otherwise specified, the following procedures were carried out at room temperature (23°C).

(Example 1)

<Preparation of Mixed Solution>

A mixed solution was prepared so that the content of carbon nanotubes and the content of PEDOT/PSS were 1 (50% by mass) : 1 (50% by mass) with respect to the total amount of a first coating film (solid content of a p-type material for thermoelectric conversion). Specifically, 50 g of a carbon nanotube dispersion (concentration: 0.2% by mass, aqueous dispersion, single-walled carbon nanotube (diameter: 0.9 to 1.7 nm, G/D ratio: 42.1)) was concentrated by vacuuming until the concentration of the carbon nanotubes reached 0.4% by mass. Subsequently, 8.3 g of a PEDOT/PSS aqueous dispersion ("Clevious (registered trademark) PH 1000" manufactured by Heraeus Group, solid content concentration: 1.2% by mass) and the concentrated carbon nanotube dispersion were sufficiently stirred (stirring time: 30 minutes) with Three-One-Motor ("PM 203 type" manufactured by AS ONE Corporation). Subsequently, the mixture was sufficiently defoamed (treatment time: three minutes) with a planetary centrifugal mixer ("Awatori Rentaro ARE -310" manufactured by THINKY Corporation) to prepare a mixed solution.

<Formation of First Coating Film>

A polyimide film (a thickness of 25 μm) washed with acetone was used, and 5 g of the mixed solution was disposed thereon, applied using a doctor blade having a gap of 2.7 mm, and placed in a blower dryer set at 60°C and dried for 2 hours. As a result, a first coating film was formed on the polyimide film.

<Immersion Treatment of First Coating Film>

The first coating film on the polyimide film obtained as described above was cut into a size of 1.0 cm × 1.0 cm. The first coating film that has been cut was immersed in 3 mL of dimethyl sulfoxide (DMSO) at room temperature for 120 minutes. Thereafter, the first coating film was placed on a hot plate set at 60°C for 120 minutes to obtain a second coating film exposed to DMSO. For the measurement of the film thickness, a high-accuracy digimatic micrometer (MDH-25MB, manufactured by Mitutoyo Corporation) was used. The film thickness of the portion where the second coating film was formed and the film thickness of the portion where only the polyimide film was present were each measured, and the

difference therebetween was calculated as the film thickness of the second coating film. The film thickness of the second coating film was 20.3 μm.

<Preparation of Dopant Solution>

A 20 mM (mmol/L) sodium hydroxymethanesulfinate aqueous solution was prepared by dissolving 0.031 g of sodium hydroxymethanesulfinate dihydrate in 10 mL of water.

<Addition of Dopant Solution>

The obtained second coating film was disposed on a hot plate heated to 140°C. Then, 0.11 mL/$cm^2$ of the above-described dopant solution was added dropwise onto the second coating film using a pipettor. Thereafter, the solvent was left to stand for 20 minutes to be removed, and a thermoelectric conversion film of Example 1 was obtained.

<Measurement of Thermoelectric Conversion Characteristics>

For the thermoelectric conversion film of Example 1, a Seebeck coefficient (S), an electric conductivity (σ), and a power factor (PF) were measured by the following methods. The thermoelectric conversion film had a Seebeck coefficient of -21.6 μV/K, an electric conductivity of 832 S/cm, and a power factor of 39 μW/($mK^2$).

· Seebeck Coefficient

The Seebeck coefficient of the thermoelectric conversion film was measured by the following method.

The thermoelectric conversion film disposed on the polyimide film was cut into a size of 10 mm × 10 mm to prepare a test piece. One end of the long side of the test piece was cooled (the initial temperature of the test piece - 5°C = 18°C), the other end of the long side of the test piece was heated (the initial temperature of the test piece + 5°C = 28°C), the temperature difference generated between both ends and the voltage at both ends were measured with an alumel-chromel thermocouple, and the Seebeck coefficient was calculated from the inclination of the temperature difference and the voltage.

· Electric Conductivity

The electric conductivity was measured by the four-point probe method (resistivity meter Loresta GP model MCP-T610, probe: QPP, manufactured by Nitto Seiko Analytech Co., Ltd. (former Mitsubishi Chemical Analytech Co., Ltd.) was used).

· Power Factor

The power factor (PF) was determined by the following formula.

$$PF = S^2\sigma$$

(S: Seebeck coefficient (V/K), σ: electric conductivity (S/m))

(Example 2)

A thermoelectric conversion film of Example 2 was obtained in the same manner as in Example 1 except that the concentration of sodium hydroxymethanesulfinate in the dopant solution was changed from 20 mM to 30 mM. The results of the film thickness of the second coating film and the thermoelectric conversion characteristics of the thermoelectric conversion film of Example 2 are illustrated in Table 1.

(Example 3)

A thermoelectric conversion film of Example 3 was obtained in the same manner as in Example 1 except that the concentration of sodium hydroxymethanesulfinate in the dopant solution was changed from 20 mM to 50 mM. The results of the film thickness of the second coating film and the thermoelectric conversion characteristics of the thermoelectric

conversion film of Example 3 are illustrated in Table 1.

(Example 4)

A thermoelectric conversion film of Example 4 was obtained in the same manner as in Example 1 except that the concentration of sodium hydroxymethanesulfinate in the dopant solution was changed from 20 mM to 100 mM. The results of the film thickness of the second coating film and the thermoelectric conversion characteristics of the thermoelectric conversion film of Example 4 are illustrated in Table 1.

(Comparative Example 1)

A second coating film of Comparative Example 1 was obtained in the same manner as in Example 1 except that the dopant solution was not added. The results of the film thickness of the second coating film and the thermoelectric conversion characteristics of the second coating film of Comparative Example 1 are illustrated in Table 1.

(Comparative Example 2)

A thermoelectric conversion film of Comparative Example 2 was obtained in the same manner as in Example 1 except that the concentration of sodium hydroxymethanesulfinate in the dopant solution was changed from 20 mM to 1 mM. The results of the film thickness of the second coating film and the thermoelectric conversion characteristics of the thermoelectric conversion film of Comparative Example 2 are illustrated in Table 1.

(Comparative Example 3)

A thermoelectric conversion film of Comparative Example 3 was obtained in the same manner as in Example 1 except that the concentration of sodium hydroxymethanesulfinate in the dopant solution was changed from 20 mM to 5 mM. The results of the film thickness of the second coating film and the thermoelectric conversion characteristics of the thermoelectric conversion film of Comparative Example 3 are illustrated in Table 1.

(Comparative Example 4)

A thermoelectric conversion film of Comparative Example 4 was obtained in the same manner as in Example 1 except that the concentration of sodium hydroxymethanesulfinate in the dopant solution was changed from 20 mM to 10 mM. The results of the film thickness of the second coating film and the thermoelectric conversion characteristics of the thermoelectric conversion film of Comparative Example 4 are illustrated in Table 1.

(Comparative Example 5)

A second coating film of Comparative Example 5 was obtained in the same manner as in Comparative Example 1 except that the second coating film was formed using only the carbon nanotube dispersion without using the PEDOT/PSS aqueous dispersion. The results of the film thickness of the second coating film and the thermoelectric conversion characteristics of the second coating film of Comparative Example 5 are illustrated in Table 2.

(Comparative Example 6)

A thermoelectric conversion film of Comparative Example 6 was obtained in the same manner as in Comparative Example 4 except that the second coating film was formed using only the carbon nanotube dispersion without using the PEDOT/PSS aqueous dispersion. The results of the film thickness of the second coating film and the thermoelectric conversion characteristics of the thermoelectric conversion film of Comparative Example 6 are illustrated in Table 2.

(Comparative Example 7)

A thermoelectric conversion film of Comparative Example 7 was obtained in the same manner as in Comparative Example 6 except that the concentration of sodium hydroxymethanesulfinate in the dopant solution was changed from 10 mM to 50 mM. The results of the film thickness of the second coating film and the thermoelectric conversion characteristics of the thermoelectric conversion film of Comparative Example 7 are illustrated in Table 2.

(Comparative Example 8)

A thermoelectric conversion film of Comparative Example 8 was obtained in the same manner as in Comparative Example 6 except that the concentration of sodium hydroxymethanesulfinate in the dopant solution was changed from 10 mM to 75 mM. The results of the film thickness of the second coating film and the thermoelectric conversion characteristics of the thermoelectric conversion film of Comparative Example 8 are illustrated in Table 2.

(Comparative Example 9)

A thermoelectric conversion film of Comparative Example 9 was obtained in the same manner as in Comparative Example 6 except that the concentration of sodium hydroxymethanesulfinate in the dopant solution was changed from 10 mM to 100 mM. The results of the film thickness of the second coating film and the thermoelectric conversion characteristics of the thermoelectric conversion film of Comparative Example 9 are illustrated in Table 2.

(Comparative Example 10)

A second coating film of Comparative Example 10 was obtained in the same manner as in Comparative Example 1 except that the second coating film was formed using only the PEDOT/PSS aqueous dispersion without using the carbon nanotube dispersion. The results of the film thickness of the second coating film and the thermoelectric conversion characteristics of the second coating film of Comparative Example 10 are illustrated in Table 2.

(Comparative Example 11)

A thermoelectric conversion film of Comparative Example 11 was obtained in the same manner as in Example 4 except that the second coating film was formed using only the PEDOT/PSS aqueous dispersion without using the carbon nanotube dispersion. The results of the film thickness of the second coating film and the thermoelectric conversion characteristics of the thermoelectric conversion film of Comparative Example 11 are illustrated in Table 2.

[Table 1]

| | Comp. Exam. 1 | Comp. Exam. 2 | Comp. Exam. 3 | Comp. Exam. 4 | Exam. 1 | Exam. 2 | Exam. 3 | Exam. 4 |
|---|---|---|---|---|---|---|---|---|
| Content of carbon nanotubes (with respect to the total amount of first coating film (solid content of p-type material for thermoelectric conversion) (% by mass) | 50 | 50 | 50 | 50 | 50 | 50 | 50 | 50 |
| Content of PEDOT/PSS (with respect to the total amount of first coating film (solid content of p-type material for thermoelectric conversion) (% by mass) | 50 | 50 | 50 | 50 | 50 | 50 | 50 | 50 |

(continued)

| | Comp. Exam. 1 | Comp. Exam. 2 | Comp. Exam. 3 | Comp. Exam. 4 | Exam. 1 | Exam. 2 | Exam. 3 | Exam. 4 |
|---|---|---|---|---|---|---|---|---|
| Concentration of dopant in dopant solution (mM) | - | 1 | 5 | 10 | 20 | 30 | 50 | 100 |
| Addition amount of dopant solution (mL/cm$^2$) | - | 0.11 | 0.11 | 0.11 | 0.11 | 0.11 | 0.11 | 0.11 |
| Film thickness of second coating film ($\mu$m) | 15.9 | 15.4 | 14.7 | 14.2 | 20.3 | 14.4 | 16.8 | 16.3 |
| Seebeck coefficient ($\mu$V/K) | 26.8 | 22.4 | 30.7 | 31.2 | -21.6 | -20.5 | -22.4 | -18.6 |
| Electric conductivity (S/cm) | 3443 | 2779 | 2051 | 1357 | 832 | 1361 | 1166 | 3250 |
| Power factor ($\mu$W/mK$^2$) | 247 | 140 | 193 | 132 | 39 | 57 | 59 | 112 |

[Table 2]

| | Comp. Exam. 5 | Comp. Exam. 6 | Comp. Exam. 7 | Comp. Exam. 8 | Comp. Exam. 9 | Comp. Exam. 10 | Comp. Exam. 11 |
|---|---|---|---|---|---|---|---|
| Content of carbon nanotubes (with respect to the total amount of first coating film (solid content of p-type material for thermoelectric conversion) (% by mass) | 100 | 100 | 100 | 100 | 100 | - | - |
| Content of PEDOT/PSS (with respect to the total amount of first coating film (solid content of p-type material for thermoelectric conversion) (% by mass) | - | - | - | - | - | 100 | 100 |
| Concentration of dopant in dopant solution (mM) | - | 10 | 50 | 75 | 100 | - | 100 |
| Addition amount of dopant solution (mL/cm$^2$) | - | 0.11 | 0.11 | 0.11 | 0.11 | - | 0.11 |
| Film thickness of second coating film ($\mu$m) | 18.6 | 19.7 | 19.9 | 17.7 | 35.9 | 9.1 | 12.9 |
| Seebeck coefficient ($\mu$V/K) | 25.7 | 35.7 | 29.7 | 13.6 | 9.7 | 17.9 | 36.2 |
| Electric conductivity (S/cm) | 3176 | 1219 | 1637 | 2011 | 960 | 767 | 35 |
| Power factor ($\mu$W/mK$^2$) | 210 | 155 | 144 | 37 | 9 | 25 | 5 |

As illustrated in Table 1, the thermoelectric conversion films of Examples 1 to 4, in which sodium hydroxymethanesulfinate was used as the dopant and the dopant solution having a predetermined concentration was added, exhibited a negative Seebeck coefficient, and demonstrated the performance as the n-type material for thermoelectric conversion. On the other hand, the second coating film of Comparative Example 1, which was not doped with the dopant, and the thermoelectric conversion films of Comparative Examples 2 to 4, to which the dopant solution having the concentration lower than the predetermined concentration was added, each exhibited a positive Seebeck coefficient, and did not demonstrate the performance as the n-type material for thermoelectric conversion.

In addition, as illustrated in Table 2, the second coating film of Comparative Example 5 and the thermoelectric conversion films of Comparative Examples 6 to 9 composed only of carbon nanotubes, and the second coating film of Comparative Example 10 and the thermoelectric conversion film of Comparative Example 11 composed only of PEDOT/PSS exhibited the positive Seebeck coefficient even though the dopant solution was added, and did not demonstrate the performance as the n-type material for thermoelectric conversion.

As described above, it has been confirmed that the method for producing an n-type material for thermoelectric conversion of the present invention is capable of converting the p-type material for thermoelectric conversion into the n-type material for thermoelectric conversion.

## Claims

**1.** A method for producing an n-type material for thermoelectric conversion, the method comprising

a step of doping a p-type material for thermoelectric conversion containing carbon nanotubes and a conductive resin with a dopant, the dopant containing at least one compound selected from the group consisting of a sulfinate salt and a dithionite salt, wherein
the step includes:

an impregnation step of impregnating at least a part of the p-type material for thermoelectric conversion with a dopant solution containing the dopant and a solvent; and
a solvent removing step of removing the solvent, and
a concentration of the dopant in the dopant solution is 15 mM or more.

**2.** The method according to claim 1, wherein
the dopant contains at least one compound selected from the group consisting of sodium methanesulfinate, sodium hydroxymethanesulfinate, and sodium dithionite.

**3.** An n-type material for thermoelectric conversion obtained by doping a p-type material for thermoelectric conversion containing carbon nanotubes and a conductive resin with a dopant, wherein
the dopant contains at least one compound selected from the group consisting of a sulfinate salt and a dithionite salt.

**4.** The n-type material for thermoelectric conversion according to claim 3, wherein
the dopant contains at least one compound selected from the group consisting of sodium methanesulfinate, sodium hydroxymethanesulfinate, and sodium dithionite.

**5.** A thermoelectric conversion element comprising the n-type material for thermoelectric conversion according to claim 3 or 4.

**6.** A dopant which is doped into a p-type material for thermoelectric conversion containing carbon nanotubes and a conductive resin, and converts the p-type material for thermoelectric conversion into n-type, wherein
the dopant contains at least one compound selected from the group consisting of a sulfinate salt and a dithionite salt.

**7.** The dopant according to claim 6, wherein
the dopant contains at least one compound selected from the group consisting of sodium methanesulfinate, sodium hydroxymethanesulfinate, and sodium dithionite.

**INTERNATIONAL SEARCH REPORT**

International application No. **PCT/JP2023/032091**

**A. CLASSIFICATION OF SUBJECT MATTER**

***H10N 10/01***(2023.01)i; ***H10N 10/855***(2023.01)i; ***H10N 10/856***(2023.01)i; ***H10N 10/857***(2023.01)i
FI: H10N10/01; H10N10/855; H10N10/856; H10N10/857

According to International Patent Classification (IPC) or to both national classification and IPC

**B. FIELDS SEARCHED**

Minimum documentation searched (classification system followed by classification symbols)

H10N10/01; H10N10/855; H10N10/856; H10N10/857

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

JSTPlus/JST7580 (JDreamIII)

**C. DOCUMENTS CONSIDERED TO BE RELEVANT**

| Category* | Citation of document, with indication, where appropriate, of the relevant passages | Relevant to claim No. |
|---|---|---|
| A | WO 2017/154823 A1 (FUJIFILM CORP.) 14 September 2017 (2017-09-14) paragraphs [0016]-[0049], fig. 1 | 1-7 |
| A | JP 2017-112319 A (FUJIFILM CORP.) 22 June 2017 (2017-06-22) paragraphs [0013]-[0067], fig. 1 | 1-7 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **09 November 2023** | **21 November 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2023/032091**

| Patent document cited in search report | Publication date (day/month/year) | Patent family member(s) | Publication date (day/month/year) |
| --- | --- | --- | --- |
| WO 2017/154823 A1 | 14 September 2017 | US 2019/0006570 A1 paragraphs [0047]-[0134], fig. 1 | |
| JP 2017-112319 A | 22 June 2017 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2015198980 A1